# EUROPEAN PATENT APPLICATION

(11) **EP 4 632 746 A1**
(43) Date of publication of application: **15.10.2025**
(21) Application number: 24170121.8
(22) Date of filing: 12.04.2024
(51) Int. Cl.: G11C 29/00, G11C 29/02, H01L 23/538

(54) **INTERCONNECT REPAIR MULTIPLEXING**

(71) Applicant: IMEC VZW, 3001 Leuven (BE)
(72) Inventor: CHUANG, Po-Yao, 3000 Leuven (BE); MARINISSEN, Erik Jan, 3001 Heverlee (BE)
(74) Representative: Winger

(57) **Abstract**

An integrated circuit (1) comprising:
a plurality of interconnects (2) forming at least four repair chains (A, B, C, D), each repair chain (A, B, C, D) comprising:
a plurality of primary interconnects (21) for providing a signal path (3),
a spare interconnect (22), and
circuitry (4) configured for offsetting, within each repair chain, signal paths (3) so as to avoid the use of a defective primary interconnect (23), when present, within the repair chain (A, B, C, D), wherein one signal path (3) is offset to the spare interconnect (22),

wherein the plurality of interconnects (2) is arranged so that spatially neighbouring interconnects (2) belong to different repair chains (A, B, C, D).

## Description

### Technical field of the invention

The present invention relates to the field of integrated circuits, and more specifically to repairing interconnects within chiplet-based 2.5D and 3D chip designs.

### Background of the invention

The invention pertains to the field of semiconductor chip design, specifically to the testing and repair of inter-die interconnects in 2.5D and 3D chip architectures, also known as "chiplet-based" designs. These advanced packaging technologies have become increasingly important as they enable the integration of multiple dies, or chiplets, into a single package, allowing for higher performance, functionality, and integration density.

In such multi-die configurations, a large number of inter-die interconnects are used to facilitate communication between the chiplets. These interconnects are typically established through micro-bump connections. The number of such interconnects may be tens of thousands. For instance, Intel's 'Ponte Vecchio' GPU (Graphics Processing Unit) features over 75,000 micro-bump interconnects, illustrating the scale and complexity of modern interconnect systems.

However, the manufacturing process of these interconnects is not without its challenges. Defects such as short circuits and open circuits are common, with short circuits accounting for the majority of defects according to industry reports. These defects can significantly impact the functionality of the semiconductor device, making it imperative to detect and repair them before the chips are deployed in the market.

To address these defects, chips are often designed with redundant interconnects, also known as spare interconnects or "spares," which can be used to replace defective interconnects. The process of testing for defects and implementing repairs is critical to ensuring the quality and yield of semiconductor devices. Interconnect standards such as Advanced Interface Bus (AIB) and Universal Chiplet Interconnect Express (UCle) include guidelines and support for interconnect testing and repair.

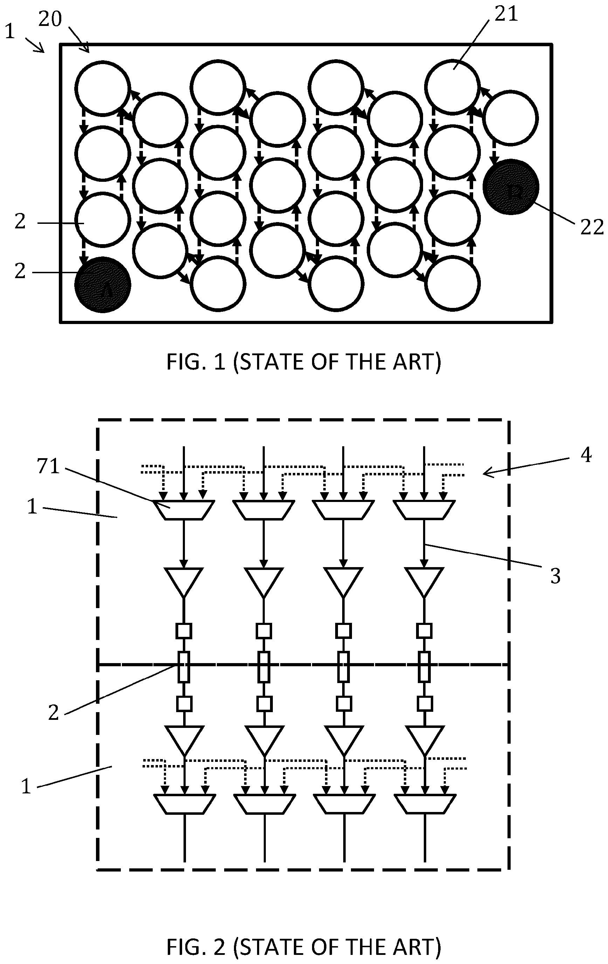

A scheme for repairing defective interconnects as known in the art, in particular, within the UCle standard, is explained with reference to FIG. 1, which is a schematic representation of a half bus of an integrated circuit 1 (or die or chiplet) comprising a plurality of interconnects 2. UCle, in its advance package modules, has buses of 64 data lanes. The standard has two spare interconnects 22 per half bus (corresponding to two spare interconnects 22 for data lanes [0...31] and two spare interconnects 22 for data lanes [32...63]). The two spare interconnects 22 per half bus sit on the two extremes of that half bus, i.e., on the far left and the far right side.

In this example, the interconnects 2 are arranged in a hexagonal array, and comprise primary interconnects 21 for providing a signal path and said spare interconnects 22. In normal operation, when none of the primary interconnects 21 is defective, the spare interconnect 22 does not provide a usable signal path (typically because, even though the spare interconnect 22 may transmit a signal, the signal is not received or "consumed" by the receiving integrated circuit, e.g., as the signal is blocked by a multiplexer at the receiving integrated circuit). However, if one of the primary interconnects is defective, said defective interconnect can no longer transmit signals. The spare interconnects 22 are provided to still enable providing a path for these signals.

In principle, repairing the integrated circuit 1 could be implemented by offsetting the signal path of the defective primary interconnect 21 directly to the spare interconnect 22. In that case, the signal that would normally be transmitted by the defective interconnect would be transmitted by the spare interconnect 22. However, this may be unfavourable if the repaired signal path is offset over a large distance, as, in that case, the signal makes a very long deroute compared to when it would be conveyed through the defective primary interconnect 21. This would result in a substantial increase of the worst-case timing that typically determines the overall signal transmission rate for the integrated circuit 1. In addition, this would require a very wide n-to-1 MUX in front of the spare interconnect to select which signal is to be repaired.

Therefore, instead, in the state of the art, the interconnects 2 typically form a repair chain 20, interconnected by circuitry for offsetting the signal path of each primary interconnect 21 to an adjacent interconnect 2 along the chain 20 in the direction of the spare interconnect 22 (indicated, in FIG. 1, by the dotted arrows leaving from each primary interconnect 2 towards adjacent interconnects 2 along the chain 20). The interconnects 2, in this example, form a single repair chain 20 comprising two spare interconnects 22 at the ends of the chain 20. The adjacent interconnect 2 to which the signal path of the primary interconnect 21 is offset does not need to be a spare interconnect 22 itself, but may be a primary interconnect 21, in which case the signal path of said adjacent primary interconnect 21 will, in turn, also be offset one interconnect 2 into the direction of the spare interconnect along the repair chain 20. This is done iteratively, until finally the spare interconnect 22 is reached. By using such a repair chain 20, each signal path - including that of the defective interconnect - is only slightly offset, so that the largest delay amongst the signals transmitted is limited as well. Thus, using the repair chain 20 strongly limits the impact of a repair on the worst-case timing of signal transmission for the integrated circuit 1.

FIG. 2 shows part of the electrical circuitry 4 that may be used to implement the repair chain 20 of FIG. 1, wherein two integrated circuits 1 (or dies or chiplets) are bonded onto each other. In FIG. 1, the integrated circuits 1 do not contain a defective interconnect. The interconnects 2 of both integrated circuits 1 are electrically connected to each other. A (conceptual) three-to-one multiplexer 71 at the input of each interconnect 2 of the top integrated circuit 1 allows for selecting which signal is transmitted by each interconnect 2. In absence of a defective interconnect 2, signals follow the signal paths 3 indicated by the arrows with solid lines.

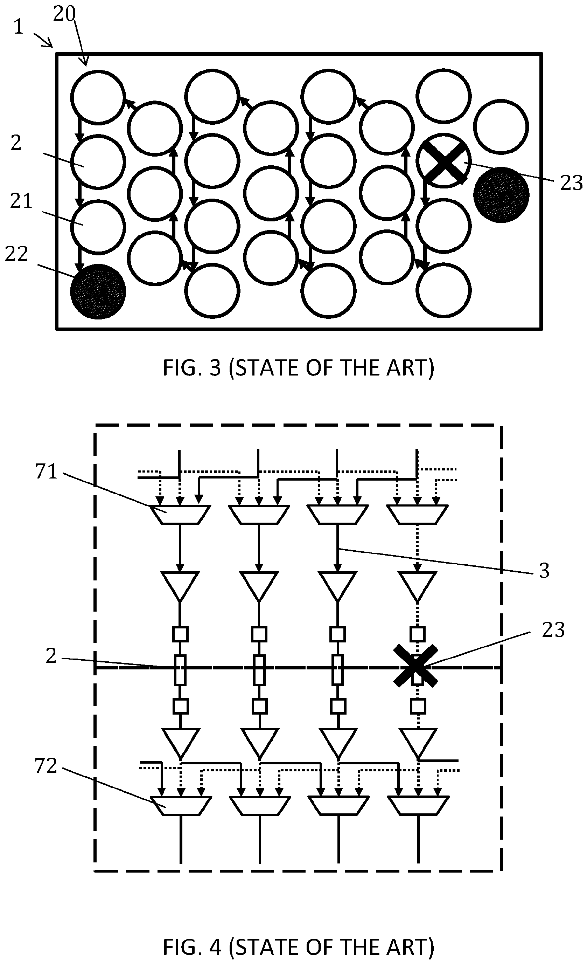

FIG. 3 shows the same integrated circuit 1 as FIG. 1, but with a defective primary interconnect 23 (indicated by the cross). The circuitry of the integrated circuit 1 offsets, within the repair chain 20, signal paths from primary interconnects 21 towards adjacent interconnects 2 - as indicated by the solid arrows - so as to avoid the use of the defective primary interconnect 23. FIG. 4, showing the circuitry 4 of FIG. 2 but now with the defective primary interconnect 23, indicates how the signal paths 3 (indicated by the arrows with solid lines) may be offset: the three-to-one multiplexer 71 at the input of the primary interconnect 2 adjacent to the defective primary interconnect 23, now selects the signal that would otherwise be transmitted by the defective primary interconnect 23. In turn, the signal that would, in absence of the defective primary interconnect 23, be transmitted by said adjacent interconnect 2, is now selected by the three-to-one multiplexer 71 at the input of a primary interconnect 2 adjacent thereto, et cetera, until a signal is finally transmitted by the spare interconnect 22. At the output of each interconnect 2, another three-to-one multiplexer 72 may be provided for guiding the offset signal back towards its original destination, i.e., the intended destination when the defective primary interconnect 23 would not be defective and would convey the signal.

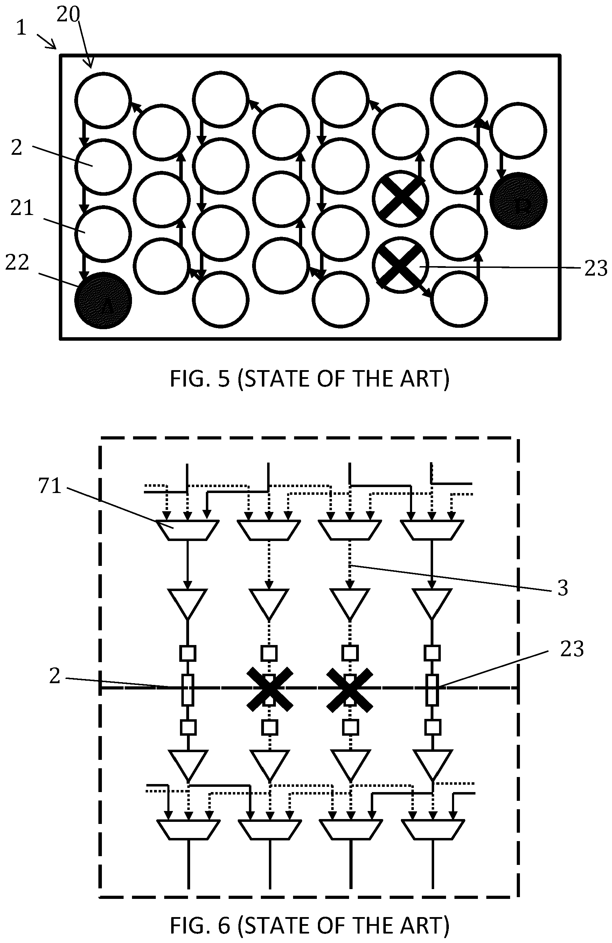

When only a single primary interconnect 2 is defective, a single spare interconnect 22 would suffice within the chain 20. However, a short circuit defect - which is an often occurring defect -affects at least two interconnects 2 and often requires both interconnects 2 to be repaired. A situation with two defective interconnects 23 is shown in FIG. 5 and FIG. 6, wherein signal paths of the defective interconnects 23 are offset in opposite directions along the chain 20, away from the defective interconnects 23, towards the spare interconnect 22. Hence, the UCle standard allows repairing one short defect or two open defects per half bus. (Unused spare interconnects 22 in one half bus cannot be used for additional repairs in the other half bus.)

As two spare interconnects 22 are provided, a (conceptual) three-to-one multiplexer is required, although this can be implemented with two cascaded two-to-one multiplexers (see CUI, Changming, et al. Physical-aware Interconnect Testing and Repairing of Chiplets. In: 2023 IEEE European Test Symposium (ETS). IEEE, 2023. p. 1-4). Such a three-to-one multiplexer requires two select signals, which is not optimal, because with two select signals, you could potentially control a 4-to-1 multiplexer. In addition, a three-to-one multiplexer or two cascaded two-to-one multiplexers add a non-negligible propagation delay compared to a two-to-one multiplexer. In addition, a three-to-one multiplexer takes about twice the silicon area in comparison to a two-to-one multiplexer. This difference becomes particularly significant as integrated circuits may have tens of thousands of interconnects, and may thus require an equal number of multiplexers.

Thus, despite the advancements in interconnect design and the inclusion of repair capabilities in standards like UCle, there are still significant challenges that need to be addressed. As is clear from the above, the repair process itself can introduce concerns. When an interconnect is repaired, it is desirable to minimize the length of the detour taken by the signal path to avoid significant increases in propagation delay. Current repair strategies, such as those outlined in the UCle standard above, may involve complex multiplexing schemes that can add to the propagation delay and require multiple select signals, which is not optimal.

Given these challenges, there is a clear need for further advancements in the field of interconnect testing and repair. Improved methods and designs that can efficiently test for a realistic set of defects, minimize the impact on signal propagation, and optimally use available select control signals as well as available silicon area, would represent a significant step forward in the manufacturing and reliability of 2.5D and 3D chip designs.

### Summary of the invention

It is an object of embodiments of the present invention to provide a good integrated circuit, and good methods of repairing said integrated circuit.

This objective is accomplished by an integrated circuit according to embodiments of the invention.

It is an advantage of embodiments of the present invention that a good repair capacity of defective interconnects in integrated circuits may be obtained.

It is an advantage of embodiments of the present invention that a limited number of spare interconnects or "spares" may be needed to perform said repairing.

It is an advantage of embodiments of the present invention that the circuitry that is required for said repairing may be efficient. It is an advantage of embodiments of the present invention that the number of control signals required for said repairing may be limited. It is a further advantage of embodiments of the present invention that the area that may be required for the repair chain may be limited, as the present invention allows for the use of two-to-one multiplexers, requiring an area that is only about a half of that required by three-to-one multiplexers.

In a first aspect, the present invention relates to an integrated circuit comprising a plurality of interconnects forming at least four repair chains. Each repair chain comprises a plurality of primary interconnects for providing a signal path and a spare interconnect. Each repair chain further comprises circuitry configured for offsetting, within each repair chain, signal paths so as to avoid the use of a defective primary interconnect, when present, within the repair chain, wherein one signal path is offset to the spare interconnect. The plurality of interconnects is arranged so that spatially neighbouring interconnects belong to different repair chains.

The primary interconnects are typically the main conductive pathways that are intended to carry signals during normal operation of the integrated circuit. These are the default pathways that are used unless a defect is detected. The spare interconnect is typically an additional conductive pathway included within a repair chain that is not used as a signal path during normal operation (typically because signals transmitted over the spare interconnect would be blocked by a multiplexer at the receiving integrated circuit), but is available to replace a primary interconnect when the latter becomes defective. The spare interconnect may be used to maintain the functionality of the integrated circuit by providing an alternative signal path in case of a defect.

Short circuits typically occur between spatially neighbouring interconnects, wherein a direct electrical connection is formed between said spatially neighbouring interconnects. The shorted spatially neighbouring interconnects cannot be adequately or reliably used for conveying signals and are deemed defective. As, in the present invention, the different spatially neighbouring interconnects are comprised in different repair chains, in a typical situation when a short circuit occurs in the integrated circuit of embodiments of the present invention, each repair chain typically contains at most a single defective interconnect. It is, therefore, an advantage of embodiments of the present invention that efficient and simple circuitry for repairing said short circuit may be employed.

In embodiments, the integrated circuit may comprise means for determining whether a primary interconnect is defective. The integrated circuit may be configured for performing said offsetting within a repair chain when it has determined that a primary interconnect within said chain is defective, that is, when it detected a defective primary interconnect within said chain. Said means for determining whether a primary interconnect is defective may comprise a test circuit, a sensor, diagnostic software that may be executed by a processor, or other mechanisms that can detect faults such as open circuits, short circuits, or degraded signal quality. Examples of specific embodiments include built-in self-test (BIST) circuits. In alternative embodiments, means for determining whether a primary interconnect is defective may be provided externally to the integrated circuit, and may, for example, comprise external testing equipment. Typically, scan test patterns are used to detect whether a primary interconnect is defective.

In embodiments, the circuitry may be configured for offsetting the signal path of each primary interconnect along the repair chain between, and including, said defective primary interconnect, when present, and a last primary interconnect adjacent along the repair chain to the spare interconnect, from said primary interconnect to an adjacent interconnect along the repair chain in a direction towards the spare interconnect. It is an advantage of these embodiments that the signal path associated with the defective primary interconnect is efficiently rerouted resulting in a limited signal delay. Indeed, if, instead, the signal path of the defective primary interconnect would be offset to the defective primary interconnect when it is not the adjacent interconnect with respect to the defective primary interconnect, said signal path may be considerably elongated. As a result, a signal transmitted along said elongated signal path may be transmitted particularly slowly. As the efficiency of signal transmission within the integrated circuit typically depends on the slowest transmitted signal, it is typically more efficient for signal transmission to offset each signal path only over a small distance, i.e., to the adjacent interconnect along the repair chain. In that case, the transmission of each signal by the repair chain may be slightly delayed, but the overall efficiency of signal transmission within the integrated circuit may be good.

In embodiments, the integrated circuit may comprise, at a signal input of the interconnects, means for providing two-to-one multiplexing for selecting between the signals of two adjacent interconnects along the repair chain. It is an advantage of embodiments of the present invention that two-to-one multiplexing is adequate for the functioning of the repair chain. It is an advantage of these embodiments that the complexity and area required for multiplexing, as well as propagation delay, may be limited. The means for providing two-to-one multiplexing may be any component or arrangement that can select one of two input signals to be passed on as a single output signal. This typically involves a multiplexer or a set of switches that can be controlled to choose between the signals of two adjacent interconnects along the repair chain. Examples of specific embodiments include electronic multiplexers and programmable logic devices. Using said means for providing two-to-one multiplexing may minimize any propagation delay. Importantly, the area that may be needed for the means for providing two-to-one multiplexing may be much less, e.g., only about a half, of that required by means for providing three-to-one multiplexing, which are typically required when state-of-the-art repair chain configurations are used.

In embodiments, each repair chain may contain a single, or not more than one, spare interconnect. It is an advantage of embodiments of the present invention that the single spare interconnect within each repair chain may suffice to provide good repair functionality. It is an advantage of these embodiments that the repair chain design may be simple. It is an advantage of these embodiments that the number of required spare interconnects may be limited. In embodiments, said single spare interconnect may be located at an end of the repair chain.

In embodiments, the plurality of interconnects being arranged so that spatially neighbouring interconnects belong to different repair chains means that each two interconnects for which a straight path between the centres of the two interconnects crosses no other interconnects, belong to different repair chains.

In common interconnect array designs, interconnects are arranged in rectangular arrays or in hexagonal arrays, although the invention is not limited thereto.

The plurality of interconnects is typically arranged in an array, wherein each interconnect occupies a node of an array template, wherein the plurality of interconnects is arranged such that, for each interconnect, at least the interconnects occupying at least eight (e.g., for any array type), and preferably at most twelve, of the spatially closest nodes of the array template belong to different repair chains than said interconnect.

In a first type of embodiments, the plurality of interconnects may be arranged in a rectangular array. In these embodiments, each interconnect may occupy a node of a rectangular array template, wherein the plurality of interconnects is arranged such that, for each interconnect, at least the interconnects occupying the eight (spatially) closest nodes of the rectangular array template belong to different repair chains than said interconnect. The rectangular array is typically an arrangement wherein rows and columns of the interconnects form right angles with each other.

In a second type of embodiments, the plurality of interconnects is arranged in a hexagonal array. In these embodiments, each interconnect may occupy a node of a hexagonal array template, wherein the plurality of interconnects is arranged such that, for each interconnect, at least the interconnects occupying the twelve (spatially) closest nodes of the hexagonal array template belong to different repair chains than said interconnect. The hexagonal array is typically an arrangement of components (i.e., the interconnects or nodes) wherein each component is equidistant from the six nearest components within the array, forming a grid of hexagonally shaped cells.

It is to be understood that the array templates mentioned above, e.g., the rectangular array template and the hexagonal array template, are typically, themselves, not physical or material arrays, but, rather, define an array of locations. Indeed, each node is, itself, not physical or material, but is a single location within the array, the nodes or locations being arranged to form a (rectangular or hexagonal) array.

In a second aspect, the present invention relates to a method of repairing an integrated circuit comprising a defective primary interconnect. The method comprises a step of providing the integrated circuit comprising a plurality of interconnects forming at least four repair chains, each repair chain comprising a plurality of primary interconnects for providing a signal path, and a spare interconnect, wherein the plurality of interconnects is arranged so that spatially neighbouring interconnects belong to different repair chains. The method further comprises a step of offsetting, within a chain comprising the defective primary interconnect, signal paths so as to avoid the use of said defective primary interconnect within the chain, wherein one signal path is offset to the spare interconnect.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic representation of an integrated circuit in accordance with the state of the art, the plurality of interconnects of the integrated circuit forming a single repair chain.
FIG. 2 is a schematic representation of two interconnected integrated circuits of FIG. 1, schematically showing the electrical circuitry containing three-to-one multiplexers for providing the repair chain functionality of the integrated circuit of FIG. 1.
FIG. 3 is the same integrated circuit of FIG. 1, but with a defective primary interconnect.
FIG. 4 is the same two interconnected integrated circuits of FIG. 2, but with a defective primary interconnect.
FIG. 5 is the same integrated circuit of FIG. 1, but with two shorted primary interconnects.
FIG. 6 is the same two interconnected integrated circuits of FIG. 2, but with two shorted primary interconnects.
FIG. 7A is a schematic representation of an integrated circuit in accordance with embodiments of the present invention, indicating, for a rectangular array of interconnects, spatially neighbouring interconnects Ax of a particular interconnect Vx.
FIG. 7B is a schematic representation of a template of potential aggressors PA for a victim V in the rectangular array of interconnects.
FIG. 8A is a schematic representation of an integrated circuit in accordance with embodiments of the present invention, indicating, for a hexagonal array of interconnects, spatially neighbouring interconnects Ax of a particular interconnect Vx.
FIG. 8B is a schematic representation of a template of potential aggressors PA for a victim V in the hexagonal array of interconnects.
FIG. 9 is a schematic representation of an integrated circuit in accordance with embodiments of the present invention, indicating, for a rectangular array of interconnects, the arrangement of the interconnects amongst four repair chains A, B, C, and D.
FIG. 10 is a schematic representation of an integrated circuit in accordance with embodiments of the present invention, indicating, for a hexagonal array of interconnects, the arrangement of the interconnects amongst four repair chains A, B, C, and D.
FIG. 11 is a schematic representation of an integrated circuit in accordance with embodiments of the present invention, indicating, for a hexagonal array of interconnects, how the signal paths of the primary interconnects may be offset along the repair chain B, in absence of a defective interconnect.
FIG. 12 is a schematic representation of two interconnected integrated circuits of FIG. 11, schematically showing the electrical circuitry containing two-to-one multiplexers for providing the repair chain functionality of the integrated circuit of FIG. 11.
FIG. 13 is a schematic representation of an integrated circuit in accordance with embodiments of the present invention, indicating, for a hexagonal array of interconnects, how the signal paths of the primary interconnects may be offset along the repair chain B, in case of a defective interconnect.
FIG. 14 is a schematic representation of two interconnected integrated circuits of FIG. 13, schematically showing the electrical circuitry containing two-to-one multiplexers for providing the repair chain functionality of the integrated circuit of FIG. 13.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still cooperate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to an integrated circuit comprising a plurality of interconnects forming at least four repair chains. Each repair chain comprises a plurality of primary interconnects for providing a signal path and a spare interconnect. Each repair chain further comprises circuitry configured for offsetting, within each repair chain, signal paths so as to avoid the use of a defective primary interconnect, when present, within the repair chain, wherein one signal path is offset to the spare interconnect. The plurality of interconnects is arranged so that spatially neighbouring interconnects belong to different repair chains.

In a second aspect, the present invention relates to a method of repairing an integrated circuit comprising a defective primary interconnect. The method comprises a step of providing the integrated circuit comprising a plurality of interconnects forming at least four repair chains, each repair chain comprising a plurality of primary interconnects for providing a signal path, and a spare interconnect, wherein the plurality of interconnects is arranged so that spatially neighbouring interconnects belong to different repair chains. The method further comprises a step of offsetting, within a chain comprising the defective primary interconnect, signal paths so as to avoid the use of said defective primary interconnect within the chain, wherein one signal path is offset to the spare interconnect.

In developing the present invention, it was conceived to implement a plurality of repair chains for each bus of UCle (for UCle, see, e.g., Universal Chiplet Interconnect Express, Inc. Universal Chiplet Interconnect Express (UCle) Specification Revision 1.1. 2023. https: //www.uciexpress.org/specifications), each repair chain equipped with a single spare interconnect. A major advantage of such an arrangement would be that each repair chain has only a single spare, so that only a single means for providing two-to-one multiplexing per interconnect side may be needed. In that case, the necessary propagation delay inherent in the use of means for multiplexing, may be kept at a minimum, as well as the area required by the repair chain.

However, when a short circuit defect occurs, typically, two interconnects become defective. When the repair chain contains only a single spare interconnect, the repair capability of the repair chain is insufficient to repair two defective interconnects within the same repair chain. Therefore, the interconnects are preferably arranged so that every pair of interconnects that has a realistic chance to be shorted by such a defect is assigned to a different repair chain, and so that it is possible to repair both open and short defects, if present.

Now follows a derivation of the number of repair chains that is at least needed to achieve this.

In the Counting Sequence and True/Complement Algorithms, often used for testing for defective interconnect, tests are performed for finding all possible short defects between any pair of interconnects amongst the plurality of interconnects. That is rather overkill, as two interconnects that reside on opposite sides of a large micro-bump array are very unlikely to be shorted if all interconnects in between them are not shorted. Indeed, it is likely that, in case of a short defect, at least spatially neighbouring interconnects are shorted.

Spatially neighbouring interconnects may be defined as follows: two interconnects may be called spatially neighbouring if a straight path between the centers of the two interconnects does not cross a third interconnect. For ease of the following discussion, one of the two spatially neighbouring interconnects is called the "victim", while the other one is referred to as the "aggressor".

Interconnects are typically arranged in rectangular or hexagonal arrays.

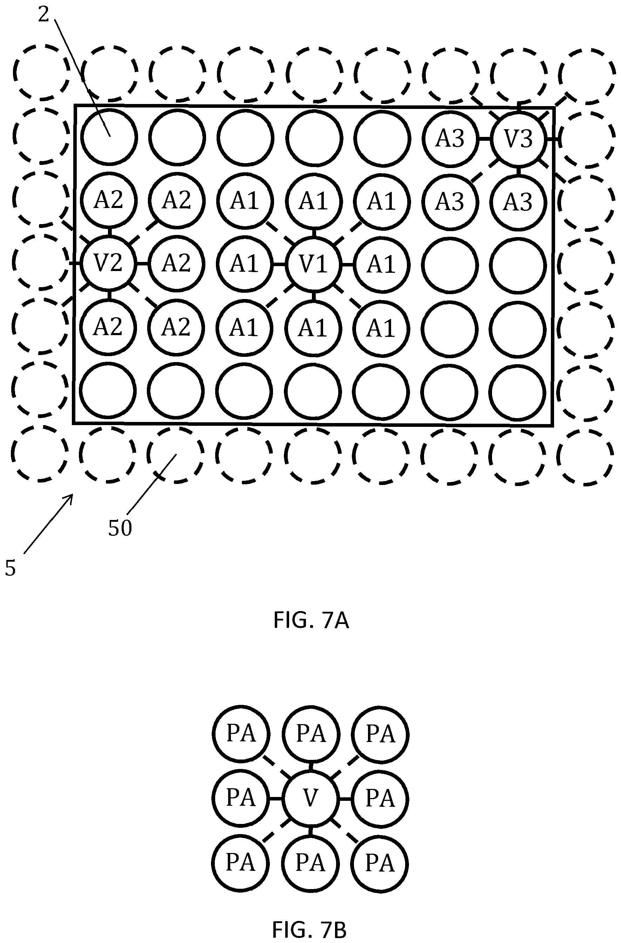

Reference is made to FIG. 7A, schematically showing an integrated circuit comprising a plurality of interconnects 2 arranged in a rectangular array. In the case of a rectangular array, each interconnect 2 may be conceived as occupying a node 50 of a rectangular array template 5, wherein said template 5 is to be construed as an imaginary, non-physical array of locations in space. The interconnects 2, occupying nodes, are indicated by circles formed of solid lines. Nodes 50 of the rectangular array template 5 not occupied by interconnects 2 are also shown as circles formed of dashed lines.

In FIG. 7A, as an example, three interconnects 2 are indicated as "victim" Vx, i.e., V1, V2 and V3. For each of these victims V1, V2 and V3, the respective spatially neighbouring interconnects or the "aggressor" Ax, i.e., A1, A2 and A3, are indicated, wherein a dashed line is drawn along the path from the centre of the victim V1, V2 and V3 to the centre of the respective aggressor A1, A2 and A3. In other words, for each victim V1, V2, and V3, all the spatially neighbouring interconnects 2, occupying the eight closest nodes 50, are indicated as the aggressor A1, A2, and A3 for said victim V1, V2, and V3, respectively.

More specifically, within a first row of interconnects 2 containing the victim V1, V2, and V3, interconnects 2 occupying the two nodes 50 spatially closest to the victim V1, V2, and V3 are considered spatially neighbouring or aggressor A1, A2, and A3; and within each of the second rows of interconnects 2 directly adjacent the first row containing victim V1, V2, and V3, interconnects 2 occupying the three nodes 50 spatially closest to the victim V1, V2, and V3 are considered spatially neighbouring or aggressor A1, A2, and A3.

As may be observed, although, in the case of the interconnect 2 indicated as victim V1, each of the eight closest nodes 50 are occupied, in the case of interconnects 2 indicated as victims V2 and V3, not each of the eight closest nodes 50 are occupied. As such, in the case of interconnect 2 indicated as victim V2, only the five closest interconnects 2 are spatially neighbouring or aggressor; and in the case of interconnect 2 indicated as victim V3, only the three closest interconnects 2 are spatially neighbouring or aggressor. As the chance on a short circuit between the victim V1, V2, and V3 and the respective aggressor A1, A2, and A3 is relatively large, it is preferred that at least each of the respective aggressors A1, A2, and A3 for each victim V1, V2, and V3 belongs to a different repair chain.

Although, in FIG. 7A, only three interconnects 2 are indicated as victim V1, V2 and V3, for which the respective aggressors A1, A2 and A3 are indicated, in principle, each interconnect 2 may be conceived as a victim.

The rectangular (micro-bump) array of interconnects 2 may be considered as a cut-out of a theoretically endless rectangular array (corresponding to the rectangular array template 5). Simultaneous reference is made to FIG. 7B, showing a (theoretical) template of potential aggressors PA (as shown in FIG. 7B) containing, in the example illustrated of the rectangular array, eight potential aggressors PA (i.e., the eight closest nodes 50, connected to the victim V, V1, V2, V3 by the dashed line) for each victim V, V1, V2, V3 on the theoretically endless rectangular array. These potential aggressors PA can either be "real" aggressors (if the potential aggressor PA falls in the cut-out - i.e., A1, A2, A3 of FIG. 7A) or "virtual" (if the potential aggressor PA falls outside the cut-out).

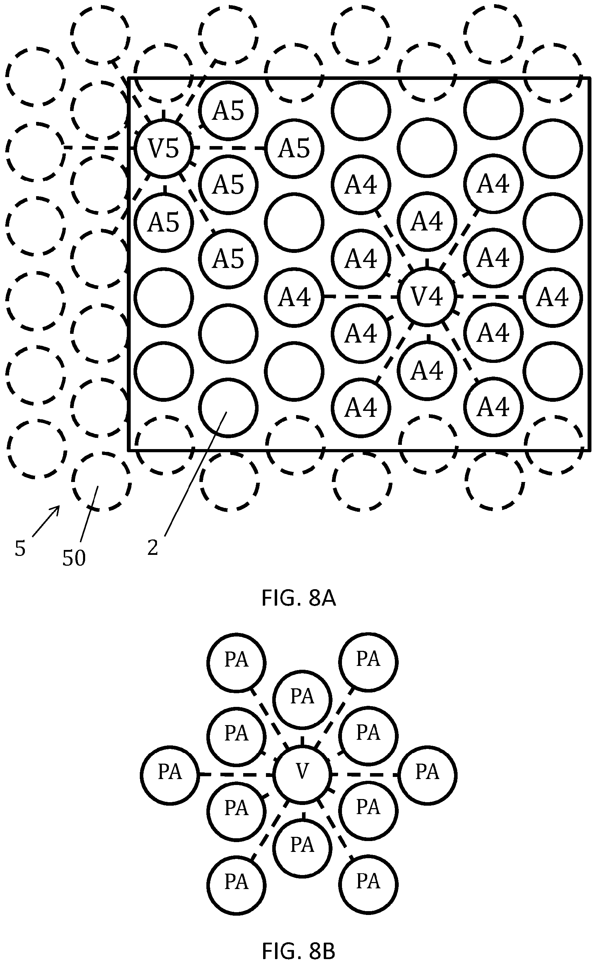

In FIG. 8A, as an example, two interconnects 2 are indicated as victim V4 and V5. For each of these victims V4 and V5, the respective spatially neighbouring interconnects or the aggressor A4 and A5, are indicated, wherein a dashed line is drawn along the path from the centre of the victim V4 and V5 to the centre of the respective aggressor A4 and A5. In other words, for each victim V4 and V5, all the spatially neighbouring interconnects 2, occupying the twelve closest nodes 50, are indicated as the aggressor A4 and A5 for said victim V4 and V5, respectively.

More specifically, within a first row of interconnects 2 containing the victim V4 and V5, interconnects 2 occupying the two nodes 50 spatially closest to the victim V4 and V5 are considered spatially neighbouring; within each of the second rows of interconnects 2 directly adjacent the first row containing victim V4 and V5, interconnects 2 occupying the four nodes 50 spatially closest to the victim V4 and V5 are considered spatially neighbouring; and within each of the third rows of interconnects 2, adjacent to the second rows and separated from the first row by the second rows, interconnects 2 occupying the single node 50 spatially closest to the victim V4 and V5 are considered spatially neighbouring.

As may be observed, although, in the case of the interconnect 2 indicated as victim V4, each of the twelve closest nodes 50 are occupied, in the case of interconnect 2 indicated as victim V5, not each of the twelve closest nodes 50 are occupied. As such, in the case of interconnect 2 indicated as victim V5, only the five closest interconnects 2 are spatially neighbouring or aggressor. As the chance on a short circuit between the victim V4 and V5 and the respective aggressor A4 and A5 is relatively large, it is preferred that at least each of the respective aggressors A4 and A5 for each victim V4 and V5 belongs to a different repair chain.

Although, in FIG. 8A, only two interconnects 2 are indicated as victim V4 and V5, for which the respective aggressors A4 and A5 are indicated, in principle, each interconnect 2 may be conceived as a victim.

The hexagonal (micro-bump) array of interconnects 2 may be considered as a cut-out of a theoretically endless hexagonal array (corresponding to the hexagonal array template 5). Simultaneous reference is made to FIG. 8B, showing a (theoretical) template of potential aggressors PA (as shown in FIG. 8B) containing, in the example illustrated of the hexagonal array, twelve potential aggressors PA (i.e., the twelve closest nodes 50, connected to the victim V, V4, V5 by the dashed line) for each victim V, V4, V5 on the theoretically endless hexagonal array. These potential aggressors PA can either be "real" aggressors A4, A5 (if the potential aggressor PA falls in the cut-out - i.e., A4, A5 of FIG. 8A) or "virtual" (if the potential aggressor PA falls outside the cut-out).The problem to be solved, of how to arrange the interconnects into repair chains in such a way that each two spatially neighbouring interconnects (or: each of the aggressors for each victim) belong to different repair chains, may be formulated as follows:
*Given:* a graph G = *(V,E),* with a set vertices *V*, corresponding to all interconnects, and a set edges E, such that an edge exists between two vertices if the corresponding interconnects are *spatially neighbouring.* Also given a positive integer *K* ≤ |*V*|, denoting the number of repair chains.
*Question:* what is the minimum number of repair chains *K* such that each two spatially neighbouring interconnects are assigned to different repair chains?

This problem is in essence identical to the NP-hard problem of graph colouring (Michael R. Garey and David S. Johnson. Computers and Intractability: A Guide to the Theory of NP-Completeness. W.H. Freeman and Company, 1979), which may be formulated as:
*Given:* a graph G = *(V,E)* and a positive integer *K* ≤ |*V*|.
*Question:* what is the minimum *K* such that graph G is K-colorable, i.e., there exists a function *f*: V--> {1,2,...,K} such that f(u) ≠ *f(v)* whenever {*u,v*} ∈ *E?*

Despite the fact that this problem is *NP*-hard, even for *K* ≥ 3, the inventors have found a solution for both array types (i.e., rectangular or hexagonal) with *K* = *4,* i.e., four repair chains.

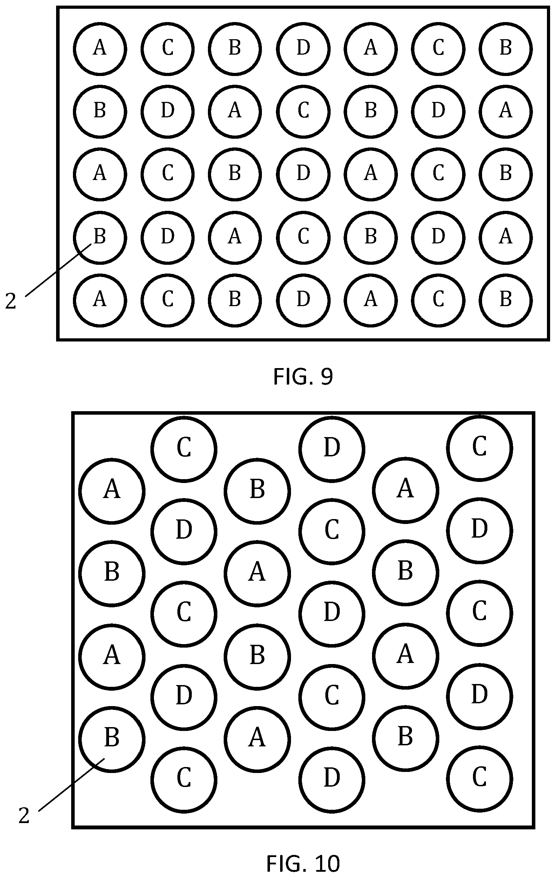

These solutions are shown schematically in FIG. 9, for the rectangular arrangement, and FIG. 10, for the hexagonal arrangement, where assignment of interconnects 2 to four different repair chain is represented by four different letters A, B, C, or D. As may be observed, for each interconnect 2 belonging to one of the four repair chains A, B, C, or D, each of the spatially neighbouring interconnects 2 belongs to a different of the four repair chains A, B, C, or D. As a result, when two spatially neighbouring interconnects 2 are short circuited thus defective, the two defective spatially neighbouring interconnects 2 each belong to a different repair chain A, B, C, or D.

Although in FIG. 9 and FIG. 10, the arrays are of limited size, they may, in essence, be an endlessly repeating pattern: it is possible to assign spatially neighbouring interconnects in arbitrarily large arrays to different repair chains as well, provided the number of repair chains is at least four.

### Example: Chiplet interconnect repair scheme for both rectangular and hexagonal arrays of interconnects

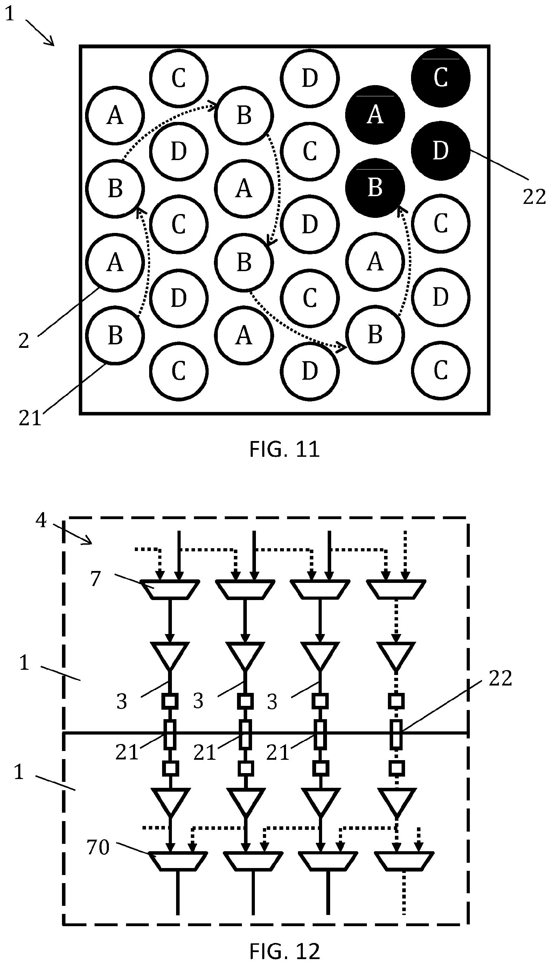

FIG. 11 shows an integrated circuit 1, wherein the interconnects 2 are arranged in a hexagonal array, in accordance with embodiments of the present invention. The interconnects 2 form four different repair chains A, B, C and D. Each of the four repair chains A, B, C and D comprises a plurality of primary interconnects 21 (in white) and a single spare interconnect 22 (in black). The dotted arrows indicate, for repair chain B, how the signal paths for the different primary interconnects 21 may be offset, towards an adjacent interconnect 2 along the repair chain B. The offsetting of the signal paths for the primary interconnects 21 of the other repair chains A, C and D is not shown for clarity, but those signal paths may be similarly offset within their respective repair chains A, C and D.

Simultaneous reference is made to FIG. 12 that shows circuitry 4 of a single repair chain B in case of no defective primary interconnect 21 in the repair chain B. In FIG. 12, two interconnected integrated circuits 1 are shown, corresponding to two stacked dies or chiplets (i.e., 3D integration), wherein the top integrated circuit 1 is adapted for sending signals and the bottom integrated circuit 1 is for receiving the signals. However, instead of the two interconnected dies or chiplets being stacked, they could be spaced and provided adjacent each other (i.e., 2.5D integration). Although only a single repair chain B is shown, circuitry having the same features could be used for the other repair chains A, C and D.

The circuitry 4 is configured for offsetting, within the repair chain B, signal paths 3 (indicated by solid lines/arrows - the dashed lines/arrows indicating paths that may be used for transmitting signals but along which, at present, no signals are transmitted) so as to avoid the use of a defective primary interconnect, when present, within the repair chain B, wherein one signal path 3 is offset to the spare interconnect 22. As the signal paths 3 have to be offsetable in only a single direction, this offsetting may be implemented by means for providing two-to-one multiplexing 7 at the input and means for providing two-to-one multiplexing 70 at the output of the primary interconnect 21, for selecting between the signal that would normally be transmitted by the primary interconnect 21 (in absence of a defective interconnect in the repair chain) and a signal that would normally be transmitted by an adjacent primary interconnect 21 (in case of a defective interconnect in the repair chain). Also the spare interconnect 22 may be provided with means for providing two-to-one multiplexing 7 at the input and (in principle, but not shown here) means for providing two-to-one multiplexing at the output of the spare interconnect 22, for selecting between no signal (in absence of a defective interconnect in the repair chain) and a signal that would normally be transmitted by an adjacent primary interconnect 21 (in case of a defective interconnect in the repair chain). A means for providing two-to-one multiplexing at the output of the spare interconnect 22 is, however, not needed. The means for providing two-to-one multiplexing 7 at the input of the spare interconnect 22 may be replaced by a simple switch.

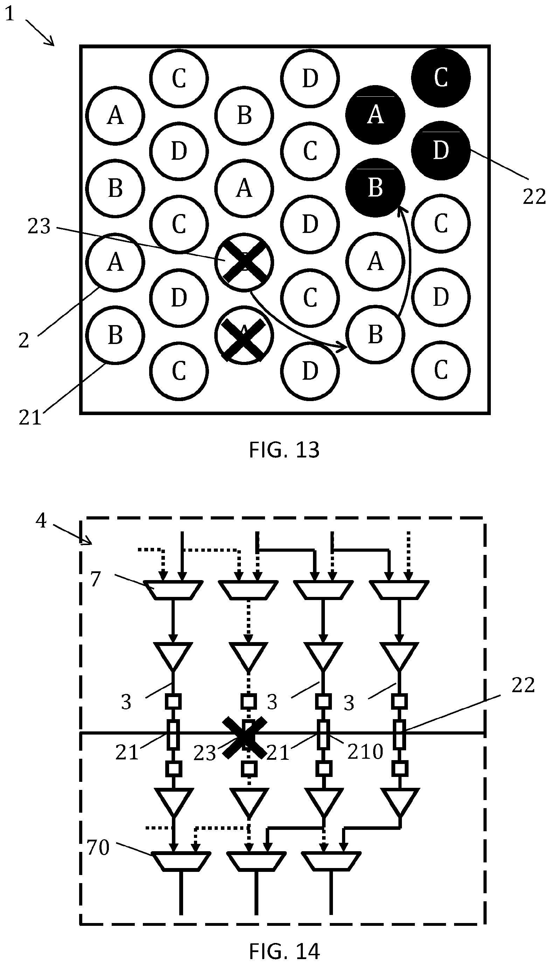

FIG. 13 shows the integrated circuit 1 of FIG. 11, but with a short between two spatially neighbouring primary interconnects 21 - one of the repair chain A and one of the repair chain B. Simultaneous reference is made to FIG. 14, showing the corresponding circuitry 4 of the repair chain B.

The solid arrows in FIG. 13 indicate how the signal paths 3 are offset so as to avoid the use of the defective primary interconnect 23 (indicated by the cross), within the repair chain B, wherein one signal path 3 is offset to the spare interconnect 22.

The solid lines/arrows in FIG. 14 indicate how the signal paths 3 are offset of each primary interconnect 21 along the repair chain B between, and including, said defective primary interconnect 23, and a last primary interconnect 210 adjacent along the repair chain to the spare interconnect 22, from said primary interconnect 21, 210 to an adjacent interconnect 2 along the repair chain 20 in a direction towards the spare interconnect 22. One signal path 3 - that of the last primary interconnect 210 - is offset to the spare interconnect 22.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. An integrated circuit (1) comprising:
a plurality of interconnects (2) forming at least four repair chains (A, B, C, D), each repair chain (A, B, C, D) comprising:
a plurality of primary interconnects (21) for providing a signal path (3),
a spare interconnect (22), and
circuitry (4) configured for offsetting, within each repair chain, signal paths (3) so as to avoid the use of a defective primary interconnect (23), when present, within the repair chain (A, B, C, D), wherein one signal path (3) is offset to the spare interconnect (22),
wherein the plurality of interconnects (2) is arranged so that spatially neighbouring interconnects (2) belong to different repair chains (A, B, C, D).

2. The integrated circuit (1) of claim 1, comprising means for determining whether a primary interconnect (21) is defective.

3. The integrated circuit (1) of any of the previous claims, wherein the circuitry (4) is configured for offsetting the signal path (3) of each primary interconnect (21) along the repair chain (A, B, C, D) between, and including, said defective primary interconnect (23), when present, and a last primary interconnect (210) adjacent along the repair chain to the spare interconnect (22), from said primary interconnect (21) to an adjacent interconnect (2) along the repair chain (A, B, C, D) in a direction towards the spare interconnect (22).

4. The integrated circuit (1) of claim 3, comprising, at a signal input (24) of the interconnects (2), means for providing two-to-one multiplexing for selecting between the signals of two adjacent interconnects (2) along the repair chain (A, B, C, D).

5. The integrated circuit (1) of any of the previous claims, wherein each repair chain (A, B, C, D) contains a single spare interconnect (22).

6. The integrated circuit (1) of claim 5, wherein said single spare interconnect (22) is located at an end of the repair chain (A, B, C, D).

7. The integrated circuit (1) of any of the previous claims, wherein the plurality of interconnects (2) is arranged so that spatially neighbouring interconnects (2) belong to different repair chains (A, B, C, D) means that each two interconnects (2) for which a straight path between the centres of the two interconnects (2) crosses no other interconnects (2), belong to different repair chains (A, B, C, D).

8. The integrated circuit (1) of any of the previous claims, wherein the plurality of interconnects (2) is arranged in a rectangular array.

9. The integrated circuit (1) of claim 8, wherein each interconnect (2) occupies a node (50) of a rectangular array template (5), wherein the plurality of interconnects (2) is arranged such that, for each interconnect (2), at least the interconnects (2) occupying the eight closest nodes (50) of the rectangular array template (5) belong to different repair chains (A, B, C, D) than said interconnect (2).

10. The integrated circuit (1) of any of claims 1 to 7, wherein the plurality of interconnects (2) is arranged in a hexagonal array.

11. The integrated circuit (1) of claim 10, wherein each interconnect (2) occupies a node (60) of a hexagonal array template (6), wherein the plurality of interconnects (2) is arranged such that, for each interconnect (2), at least the interconnects (2) occupying the twelve closest nodes (60) of the hexagonal array template (6) belong to different repair chains (A, B, C, D) than said interconnect (2).

12. A method of repairing an integrated circuit (1) comprising a defective primary interconnect (23), comprising:
a) providing the integrated circuit (1) comprising:
a plurality of interconnects (23) forming at least four repair chains (A, B, C, D), each repair chain (A, B, C, D) comprising:
a plurality of primary interconnects (21) for providing a signal path (3), and
a spare interconnect (22),
wherein the plurality of interconnects (2) is arranged so that spatially neighbouring interconnects (2) belong to different repair chains (A, B, C, D), and
b) offsetting, within a chain (A, B, C, D) comprising the defective primary interconnect (23), signal paths (3) so as to avoid the use of said defective primary interconnect (23) within the chain (A, B, C, D), wherein one signal path (3) is offset to the spare interconnect (22).
